Europäisches Patentamt

(19) European Patent Office

Office européen des brevets

(11) Publication number: **0 105 347**
**B1**

(12) **EUROPEAN PATENT SPECIFICATION**

(45) Date of publication of patent specification: **28.01.87**

(21) Application number: **83901544.3**

(22) Date of filing: **06.04.83**

(86) International application number:
**PCT/US83/00478**

(87) International publication number:
**WO 83/03710 27.10.83 Gazette 83/25**

(51) Int. Cl.⁴: **H 01 L 21/24, C 30 B 13/02**

(54) TEMPERATURE GRADIENT ZONE MELTING PROCESS AND APPARATUS.

(30) Priority: **09.04.82 US 366900**
**09.04.82 US 366901**

(43) Date of publication of application:
**18.04.84 Bulletin 84/16**

(45) Publication of the grant of the patent:
**28.01.87 Bulletin 87/05**

(84) Designated Contracting States:
**DE FR GB NL**

(56) References cited:
**US-A-3 301 716**
**US-A-3 897 277**

(73) Proprietor: **Hughes Aircraft Company**
**7200 Hughes Terrace P.O. Box 45066**
**Los Angeles California 90045-0066 (US)**

(72) Inventor: **BROWN, Roger H.**
**1174 E. Elmwood**
**Burbank, CA 91501 (US)**
Inventor: **CHOW, Kuen R.**
**7721 Mary Ellen Avenue**
**North Hollywood, CA 91605 (US)**
Inventor: **GOODWIN, Norman W.**
**5086 Gaynor Avenue**
**Encino, CA 91436 (US)**
Inventor: **GRINBERG, Jan**
**1141 South Carmelina Avenue**
**Los Angeles, CA 90049 (US)**

(74) Representative: **Colgan, Stephen James et al**
**CARPMAELS & RANSFORD 43 Bloomsbury**
**Square**
**London WC1A 2RA (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

## TECHNICAL FIELD

This invention relates to processes for fabricating semiconductor devices and, more particularly, to processes using the temperature gradient zone melting technique for fabricating three-dimensional microelectronic devices.

## BACKGROUND OF THE INVENTION

### 1. Field of the Invention

Demands for ever faster transfer of signals in digital computers have led to the advent of three-dimensionally structured microelectronic semiconductor devices for use in such computers. One such three-dimensionally structured device is disclosed in U.S. Patent No. 4,275,410, by Grinberg et al. In that device, signals are transferred through stacked semi-conductor wafers each of which is interconnected with adjacent wafers by external leads extending from both surfaces of the wafer. Transfer of signals through each wafer is provided by internal connections which are positioned between the wafer surfaces. The process for fabricating such internal connections is the subject of the present invention.

### 2. Description of the Prior Art

One process for fabricating such internal connections is a technique generally called temperature gradient zone melting; an example of which is disclosed in U.S. Patent No. 3,897,277, by Blumenfeld. In this process, a liquid zone migrates in a solid along a thermal gradient. In particular, a liquid droplet of metallic material placed on one surface of a solid wafer migrates through the solid and emerges on the wafer's second surface. The wafer is heated to an elevated temperature for establishing a thermal gradient through the wafer, the hotter temperature being at the second surface. The thermal gradient causes the temperature at the forward interface of the droplet to be higher than the temperature at its rear interface. Since the solubility of a solid in a liquid increases with temperature, the concentration of the atoms from the dissolved wafer solid is greater at the hotter forward interface of the liquid than at the cooler rear interface. The inequality in concentration produces a concentration gradient of atoms from the dissolved wafer solid across the liquid droplet. The concentration gradient, in turn, creates a flux of atoms from the dissolved wafer solid along this gradient, that is, a flow of atoms from the hotter front interface to the cooler rear interface. To feed this diffusion flux, additional atoms of the wafer solid are dissolved into the liquid at the forward interface and moved to the rear interface. Consequently, the liquid droplet migrates along the thermal gradient toward the hotter second surface, dissolving atoms of the wafer at its forward interface, passing the atoms toward the rear, and redepositing these atoms at its rear interface. At the cooler rear interface, the redeposited atoms recrystallize with traces of the droplet metalic material in them. Thus, the path left by the migrating liquid droplet is higher in conductivity than the rest of the wafer. The conductive path, extending from one wafer surface to another, is the internal connection necessary for the operation of a three-dimensional microelectronic device. However, prior art processes employing the temperature gradient zone melting technique are deficient in several aspects.

One deficiency in the prior art is the inability of the prior art processes to produce a high thermal gradient through the wafer. Since the thermal gradient in a wafer is generally proportional to the quantity of heat that flows through the wafer and correspondingly the migration rate of the droplets is generally proportional to the thermal gradient, the quantity of heat flowing through the wafer should be as high as possible. However, both the duration that the wafer is exposed to the heat and the quantity of heat itself invariably cause defects in the wafer. Thus, creating a high thermal gradient through a wafer without using an even greater quantity of heat would result in the twin benefits of faster migration rate and less exposure to heat, producing more defect-free wafers.

One prior art process of enhancing the thermal gradient through a wafer is disclosed in U.S. Patent No. 4,033,786, by Anthony et al., in which anti-reflection coatings are applied to wafer surfaces for trapping heat in the wafer. However, this and other prior art processes are still not efficient because each of them provides a gas-filled gap between the wafer and the heating source. The gas usually acts as an insulator in preventing the most efficacious transfer of heat from the heat source to the wafer, thereby requiring either more heat to flow through the wafer or longer exposure to heat in order to create the necessary thermal gradient. Examples of such processes are disclosed in U.S. Patent No. 3,895,967, by Anthony et al., and U.S. Patent No. 3,910,801, by Cline et al.

Another deficiency in the prior art is the inability of the prior art processes to provide a uniform temperature gradient through the wafer, thereby causing nonuniform droplet migration. Uniformity refers to the capability of providing both parallel heat flow lines for parallel migration of droplets and linear isotherms parallel to the wafer surfaces which indicate the establishment of the same temperature at a given depth in the wafer. Uniform droplet migration is essential in order to maximize the number of completed migrations within a certain process time limit, a completed migration being a generally vertical internal connection with exposed ends on both surfaces of the wafer. Without such uniformity, the yield of usable conductive internal connections in each wafer decreases.

The parallel heat flow line type of nonuniformity is usually caused by support pins or holders that are necessary for supporting the wafer in the heating apparatus. These pins or holders, acting like heat sinks because they are more heat conductive than the surrounding gas, create deviations in the parallel heat flow lines through the wafer. Examples of the use of such pins and holders are described in the processes disclosed in U.S. Patent No. 3,895,967, by Anthony et al., and U.S. Patent No. 4,001,047, by Boah. To alleviate this problem, support ribs and guard rings around the periphery of the wafer are used to prevent lateral heat flows. Such devices are used in processes disclosed in U.S. Patent No. 3,895,967, by Anthony et al., and U.S. Patent No. 4,035,199, by Anthony et al., respectively.

The linear isotherm type of nonuniformity occurs in infrared heating processes such as the process disclosed in T. R. Anthony and H. E. Cline, "Stresses Generated by the Thermomigration of Liquid Inclusions in Silicon", Journal of Applied Physics, Vol. 49, No. 12, December, 1978. Because silicon is semi-transparent to infrared radiation, infrared radiation is absorbed at varying depths in the wafer. The absorbed radiation, thus, provides a variety of temperatures at a given depth of the wafer, creating nonlinear isotherms through the wafer. In turn, the nonlinear isotherms created by an infrared process cause non-uniform migration of the droplets. In contrast, non-infrared processes provide the same temperature at a given depth of the wafer, thereby creating linear isotherms which are parallel to the wafer surfaces. Aluminum droplets, therefore, migrate through a uniform distance of the wafer from a lower-temperatured isotherm to a higher-temperatured isotherm during the same time period.

A general method of establishing a thermal gradient in a semiconductor material is shown in US—A—3301716.

The prior art processes are deficient in their inability to produce a high thermal gradient through the wafer and to provide a uniform temperature gradient through the wafer.

It is a purpose of the present invention to provide a temperature gradient zone melting process capable of providing a high, uniform thermal gradient through a wafer, and an apparatus for use in such process.

According to the invention there is provided a process for fabricating a semiconductor device by thermal gradient zone melting comprising the steps of:

a) selecting a wafer body of semiconductor material which is of one type of conductivity, said body having two major generally parallel opposed surfaces, said opposed surfaces being respectively the top and bottom surfaces;

b) depositing an array of droplets in solid form on said top surface, said droplets comprising metal-rich conductive material;

c) applying a layer of a buffer material on the entire area of said bottom surface, said buffer material having the characteristic of being insoluble with said droplets, said layer thereby being in direct contact with said bottom surface and said heating surface when said bottom surface is placed intimately adjacent said heating surface, whereby said buffer layer terminates said migration of said droplets to prevent alloying of said droplets with said heating surface;

d) placing said wafer body on a generally planar surface of heating means with the entire area of said bottom surface intimately adjacent said heating surface;

e) heating said wafer body and said droplets to a sufficient temperature for simultaneously:

(i) establishing a thermal gradient through said wafer body wherein said bottom surface is at a higher temperature than said top surface, and

(ii) melting said droplets to enable migration of said droplets through said wafer body toward said heating surface; and

f) removing heat from said top surface to enhance the establishment of said thermal gradient; whereby said droplets form column-like paths the conductivity of which is opposite to the conductivity of said wafer body.

According to the invention there is further provided an apparatus for fabricating a semiconductor wafer by thermal gradient zone melting, said wafer having generally parallel opposed top and bottom surfaces, said apparatus comprising:

a) a base;

b) a rotatable heating means mounted on said base, said heating means having a generally planar heating surface which is capable of supporting the entire area of the bottom surface of the semiconductor wafer;

c) a source of heat conductive gas;

d) heat sink means sufficiently spaced from the heating means but in close proximity therewith, such that when a semiconductor wafer is placed on said heating means a space between said heating means and said heat sink means is formed capable of receiving a high heat conductive gas, such that said heat sink means and said gas cooperatively remove heat from within said wafer body through the top surface of said semiconductor wafer to enhance the establishment of a thermal temperature gradient; and

e) means for providing entry and exit of said heat conductive gas to and from said space.

One advantage of the present invention is that a high thermal gradient is established through the wafer. Such a high gradient results from the combination of the direct placement of the wafer on the heating surface and the efficacious cooling of the wafer by the cooperative action of both the heat sink means and the heat conductive gas. With the bottom surface of the wafer in intimate contact with the heating surface and the top surface in close proximity with the heat sink means, the desired large heat flow through the wafer is created, which in turn causes the high thermal gradient. Having the high thermal gradient and the attendant faster migration rate, either the heat flowing through the wafer may be lowered or the manufacturing time may be shortened. Either result produces more defect-free wafers.

Another advantage of the present invention is that a uniform thermal gradient is established through the wafer. The uniformity results from the intimate placement of the wafer on the heating surface. The high thermal gradient enhances parallel heat flows and eliminates lateral heat flows in order to provide substantially parallel migration of droplets. In addition, the direct conduction of heat through the wafer, as contrasted to infrared heating processes, creates uniform linear isotherms, which are parallel to the wafer surfaces. This enhances uniform droplet migration.

A further advantage of the present invention is that the buffer layer prevents the alloying or sticking of the droplets with the heating surface. The buffer layer, thus, facilitates the subsequent removal of the wafer from the heating surface.

Other purposes, features, and advantages of the present invention will appear from the following detailed description of a preferred embodiment thereof, taken together with the accompanying drawings.

### BRIEF DESCRIPTION OF THE DRAWINGS

FIG. 1 is a perspective view of stacked semiconductor wafers, the process for making such wafers being the subject of the present invention;

FIG. 2 is a simplified cross-sectional view of an apparatus useful in practising the novel process of the present invention;

FIG. 3 is a partial enlarged view of the apparatus of FIG. 2, depicting the treatment of one partially cross-sectioned wafer;

FIGS. 4 to 7 are simplified sequential cross-sectional views of the migration of one droplet through a wafer in the process of the present invention; and

FIG. 8 is an enlarged simplified cross-sectional view of FIG. 3, with a buffer layer provided between the wafer bottom surface and the heating surface in accordance with the present invention.

### DETAILED DESCRIPTION OF THE INVENTION

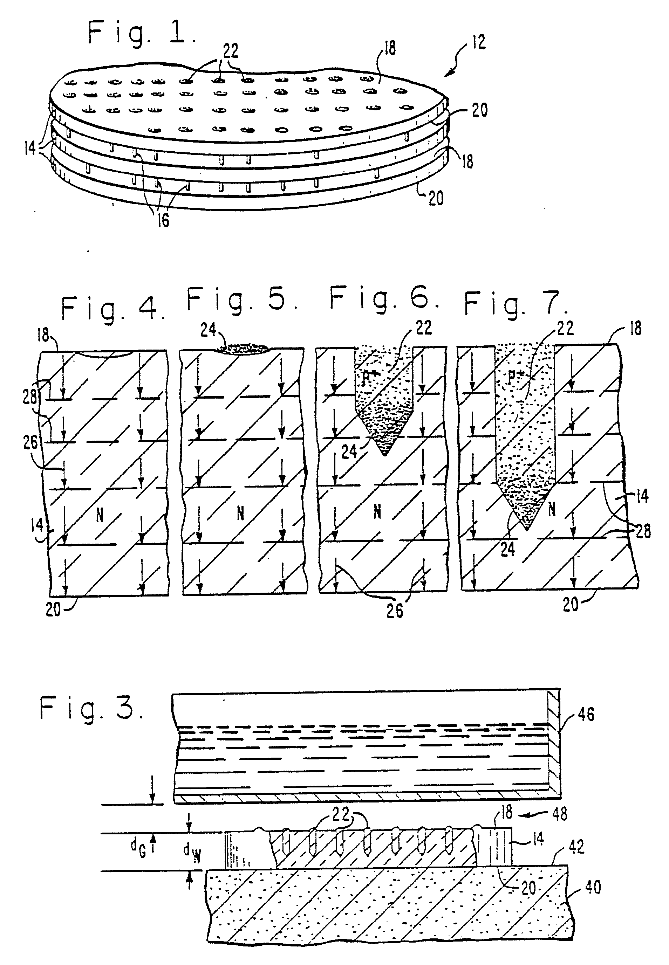

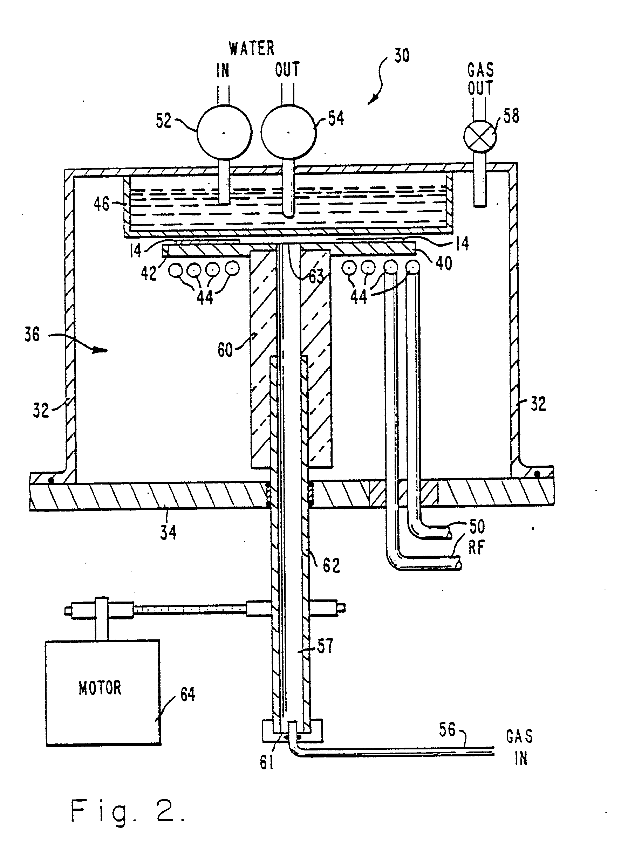

Referring to FIG. 1, there is shown a three-dimensional microelectronic device 12 which comprises a plurality of stacked semiconductor wafers 14. As an example, three of such wafers 14 are shown. Each wafer 14 is connected to another wafer 14 by external leads 16 which may extend from either of surfaces 18, 20 of wafer 14, thereby allowing the transfer of signals from one wafer 14 to another. The transfer of signals through wafer 14 is provided by internal connections 22 which are positioned between wafer surfaces 18, 20. The process for fabricating such internal connections 22 is the subject of the present invention.

The process of the present invention employs a technique generally referred to as thermal gradient zone melting. As best illustrated in the sequence of FIGS. 4 to 7, a wafer 14 of suitable semiconductor material, which is of one type of conductivity, is selected. For example, a wafer 14 of n-type silicon is selected. Wafer 14 has a top surface 18 and a bottom surface 20. Solid droplets 24, a suitable metal-rich conductive material of a conductivity such as to provide, when diffused in the wafer, a pathway of opposite conductivity, are placed on wafer top surface 18, as best shown by a representative single droplet 24 in FIG. 5. As an example, droplets 24 of aluminum are selected. In the art, droplets are generally referred to as droplets irrespective of either solid or liquid form. Moreover, droplets 24 may be deposited in a predetermined pattern, as depicted by FIG. 1.

Wafer 14 is then heated to an elevated temperature in order to establish a thermal gradient through wafer 14, with bottom surface 20 being the hotter surface. Simultaneously, aluminum droplet 24 is heated to form a liquid which is generally referred to as a liquid zone. As shown in FIGS. 6 and 7, droplet 24 then migrates through wafer 14 toward hotter surface 20. As it migrates, droplet 24 leaves a recrystallized path which is of an opposite conductivity than the conductivity of wafer 14. The column-like path, p-type silicon in the example, eventually becomes conductive connection 22.

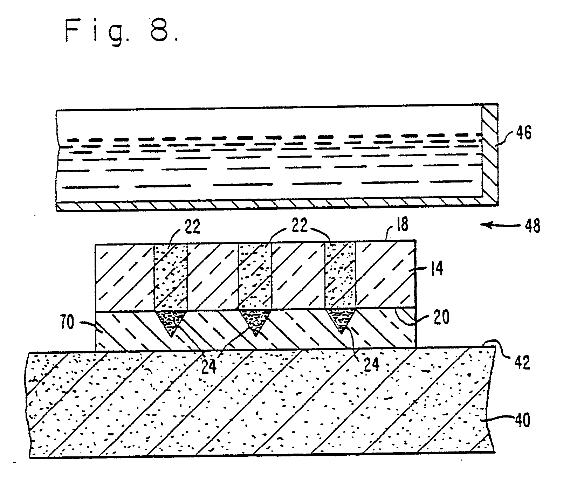

Referring now to FIG. 2, there is shown an apparatus 30 useful in practicing the novel process of the present invention. Apparatus 30 comprises removable chamber wall 32 and chamber base 34 which combine to form thermomigration chamber 36. Within chamber 36, apparatus 30 further comprises rotatable heating platform 40 which includes a generally planar heating surface 42 for supporting at least one wafer 14, two of which are shown as an example in FIG. 2. As best shown in FIGS. 3 and 8, heating surface 42 is adapted to receive the entire area of wafer bottom surface 20. Platform 40 generally comprises a heat conductive material, for example, graphite. Radio-frequency coils 44 are positioned beneath heating platform 40 to induce heat therein in order to heat wafers 14. A heat sink 46, which is spaced from heating surface 42, is provided for wafers 14. In the example, heat sink 46 is a water tank. In addition, gap 48 between wafer top surface 18 and water tank 46, as best shown in FIGS. 3 and 8, is provided to receive a gas of high heat conductivity such as hydrogen or helium. The gas may be in either a pure or a mixed form. In the example, helium is selected. The cooperative action of water tank 46 and the gas removes heat from wafer 14 to enhance the establishment of the desired thermal gradient through wafer 14.

Furthermore, apparatus 30 comprises radio-frequency conductors 50 which, exiting through chamber base 34, are connected to a radio frequency source, not shown. Heating platform 40 is mounted on rotatable platform drive shaft 60. Motor 64, which is connected to elevatable drive shaft 62 which in turn is connected to platform drive shaft 60, is adapted to rotate platform 40. Gas conduit 57, connected to gas entry port 56 at its external end 61, is provided within platform drive shaft 60 and drive shaft 62. Internal end 63 of gas conduit 57 is positioned adjacent heating platform 40. In addition, water entry and exit ports 52, 54, and gas entry and exit ports 56, 58 are provided.

In the preferred practice of this invention, a wafer 14 of one type of conductivity, for example, n-type silicon is selected. Wafer 14 has two major parallel opposed top and bottom surfaces 18, 20, as best shown in FIGS. 3 and 8. Wafer 14 of the preferred embodiment has a thickness, designated as $d_w$, of typically 20 mils. Next, an array of solid droplets 24 of suitable metal-rich conductive material is placed on top surface 18 of wafer 14, as best shown by the representative single droplet 24 in FIG. 5. Droplets 24 are, for example, aluminum. This array, arranged in a typical 32 × 32 matrix as similar to what is shown in FIG. 1, is applied to surface 18 by conventional techniques such as direct evaporation using a shadow mask. Each droplet 24 in the preferred embodiment, for example, is approximately 3 mils (76 μm) in diameter and 8 to 25 micrometers in height, with a droplet center-to-droplet center distance of approximately 20 mils (510 μm).

In accordance with the present invention, a buffer layer 70 is applied to the entire area of bottom surface 20, as best shown in FIG. 8. Buffer layer 70 has the characteristic of being insoluble with liquid droplets 24. Buffer layer 70, which comprises a material such as silicon dioxide or aluminum oxide, is applied to bottom surface 20 by conventional techniques such as vapor deposition. As an example, buffer layer 70 has a thickness of approximately one micrometer. In the preferred embodiment, buffer layer 70 comprises silicon dioxide of conventional purity.

In the preferred process, two wafers 14, as an example, are placed directly on graphite heating platform 40, with the entire area of wafer bottom surface 20 having buffer layer 70 thereon in direct physical contact with heating surface 42, as best shown by the single wafer 14 in FIG. 8. Referring to FIG. 2, RF coils 44 then induce eddy currents in graphite platform 40 which, being resistive in property, transforms electrical energy into heat. Coils 44 receive RF energy through conductors 50 which in turn are connected to a RF source, not shown. Simultaneously, the heat conductive gas enters chamber 36 through entry port 56 and water enters water tank 46 through entry port 52. Gap 48, $d_G$, which is approximately 5 mils (130 μm) in distance in the example, is provided to receive the gas. As wafer bottom surface 20 is heated by platform 40 and as wafer top surface 18 is cooled by the cooperative action of both the gas and water tank 46, a high thermal gradient through wafer 14 is established. The gas in gap 48, being an effective heat conductive gas, removes the heat in wafer 14 from top surface 18 and transports the heat to water tank 46 for cooling.

With the entire wafer bottom surface 20, which has buffer layer 70 thereon, in direct contact with heating surface 42, a uniform thermal gradient is also established, thereby enhancing the number of completed droplet migrations. Heat in wafer 14 generally flows in a parallel fashion, as best shown by the heat flow lines 26 in FIGS. 4 to 7, for enhancing uniform droplet migration. In addition, direct heating of wafer 14 enhances the establishment of linear isotherms 28 for uniform migration of droplets 24, as best shown in FIGS. 3 and 8. Linear isotherms 28 are parallel to wafer surfaces 18 and 20, as best shown in FIGS. 4 to 7. Rotation of platform 40 by motor 64 also provides a uniformity of heat at heating surface 42 for uniform heating of water bottom surface 20. Furthermore, for example, water of room temperature in tank 46, exiting through port 54, conveniently circulates at a rate of approximately 5—6 U.S. gallons (18.9—22.7) per minute for cooling the heat conductive gas. Similarly, for example, the gas in chamber 36, exiting through port 58, conveniently circulates at a rate of approximately 10 cubic feet (0.28 m³) per minute for transporting the heat from wafer 14 to water tank 46.

Simultaneous with the establishment of the thermal gradient through wafer 14, droplets 24 are heated to a liquid state. With a high thermal gradient established through wafer 14, liquid aluminum droplets 24 migrate uniformally toward heating surface 42, as partially shown in FIG. 3. As droplets 24 migrate through wafer 14, they leave recrystallized connecting paths 22 which are of an opposite conductivity to wafer 14, as best shown in FIGS. 3, 6, 7 and 8. For example, paths 22 are p-type silicon which contain traces of aluminum. Typically, each of the resultant internal connections 22 has a resistance of approximately 5 to 15 ohms.

A buffer layer 70 is applied to the entire area of bottom surface 20, interposing between bottom surface 20 and heating surface 42. Buffer layer 70 has the characteristic of being insoluble with liquid droplets 24. This enables buffer layer 70 to trap and terminate the migration of droplets 24, thereby preventing alloying or sticking of droplets 24 with heating surface 42. Buffer layer 70, thus facilitates the subsequent removal of wafer 14 from heating surface 42. Buffer layer 70 comprises a material such as silicon dioxide or aluminum oxide.

Buffer layer 70, which is silicon dioxide of conventional purity in the example, is applied to wafer bottom surface 20 by conventional techniques such as vapor deposition. Buffer layer 70, for example, is approximately one micrometer in thickness. After removal from heating surface 42, buffer layer 70 is removed by conventional resurfacing techniques such as grinding and polishing.

With the heat flowing through wafer 14 at approximately the typical temperature of 1000°C, a thermal gradient of 250°C/cm is established through wafer 14 in accordance with the invention. The resultant thermal gradient is approximately 2 to 5 times larger than the gradients disclosed in the prior art. The comparatively high thermal gradient allows the migration of droplets 24 to be completed in approximately 10 minutes. With wafers 14 being exposed to chamber heat for only such a comparatively short duration, more defect-free wafers are manufactured. Moreover, such a comparatively high thermal gradient enhances uniform migration of droplets 24, which in turn produces more wafers with completed migrations.

It will be apparent to those skilled in the art that various modifications may be made within the scope of the invention as defined by the appended claims. For example, the distance of gap 48, $d_G$, may be narrowed. Because the thermal gradient generally corresponds inversely to the distance of gap 48, a narrowing of distance $d_G$ to 2 mils (51 μm) increases the thermal gradient across wafer 14. This is due to the fact that water tank 46 is now closer to wafer 14 and is able to provide more heat removing capability. The narrowing of $d_G$ is accomplished by elevating drive shaft 62, which in turn elevates platform 40 and wafer 14 supported thereon.

The narrowing of $d_G$ allows the process to proceed at either an even faster migration rate or a lower temperature. The lower temperature process permits migrations in a lower thermal gradient. Either selection results in even more defect-free wafers.

## Claims

1. A process for fabricating a semiconductor device by thermal gradient zone melting comprising the steps of:

a) selecting a wafer body (14) of semiconductor material which is of one type of conductivity, said body having two major generally parallel opposed surfaces (18, 20) said opposed surfaces being respectively the top (18) and bottom (20) surfaces;

b) depositing an array of droplets (24) in solid form on said top surface, said droplets comprising metal-rich conductive material;

c) applying a layer of a buffer material (70) on the entire area of said bottom surface, said buffer material having the characteristic of being insoluble with said droplets, said layer thereby being in direct contact with said bottom surface and said heating surface when said bottom surface is placed intimately adjacent said heating surface, whereby said buffer layer terminates said migration of said droplets to prevent alloying of said droplets with said heating surface;

d) placing said wafer body on a generally planar surface of heating means (40) with the entire area of said bottom surface intimately adjacent said heating surface;

e) heating said wafer body and said droplets to a sufficient temperature for simultaneously:

(i) establishing a thermal gradient through said wafer body (14) wherein said bottom surface (20) is at a higher temperature than said top surface (18), and

(ii) melting said droplets (24) to enable migration of said droplets through said wafer body toward said heating surface; and

f) removing heat from said top surface to enhance the establishment of said thermal gradient; whereby said droplets form column-like paths the conductivity of which is opposite to the conductivity of said wafer body.

2. A process according to claim 1, wherein said wafer body comprises silicon.

3. A process according to claim 2, wherein said wafer body comprises n-type silicon and said droplets comprise aluminum.

4. An apparatus for fabricating a semiconductor wafer by thermal gradient zone melting, said wafer having generally parallel opposed top and bottom surfaces, said apparatus comprising:

a) a base (34);

b) a rotatable heating means (40) mounted on said base, said heating means having a generally planar heating surface which is capable of supporting the entire area of the bottom surface of the semiconductor wafer;

c) a source of heat conductive gas;

d) heat sink means (46) sufficiently spaced from the heating means (40) but in close proximity therewith, such that when a semiconductor wafer is placed on said heating means a space (48) between said heating means and said heat sink means is formed capable of receiving a high heat conductive gas, such that said heat sink means and said gas cooperatively remove heat from sink means and said gas cooperatively remove heat from within said wafer body through the top surface of said semiconductor wafer to enhance the establishment of a thermal temperature gradient; and

e) means in communication with said source of heat conductive gas for providing entry (56) and exit (58) of said heat conductive gas to and from said space (48).

5. An apparatus according to claim 4 further comprising an upper wall (32) adapted to be removably mounted on said base (34), thereby defining an enclosed chamber containing said heating means (40), said heat sink means (46), and said gas space (48) therein.

6. An apparatus according to claim 4 or 5, wherein said heat sink means (46) comprises a tank to receive cooling water therein.

7. An apparatus according to any of claims 4 to 6, wherein said rotatable heating means comprises a graphite platform and radio-frequency coils (44) are positioned adjacent said graphite platform for inducing heat-generating currents therein.

## Patentansprüche

1. Verfahren zur Herstellung einer Halbleitervorrichtung durch Temperaturgradienten-Zonenschmelzen, enthaltend die Schritte:

a) Auswählen eines Wafer-Körpers (14) aus Halbleitermaterial, das von einem Typ an Leitfähigkeit ist, wobei der Körper zwei gegenüberliegende, im allgemeinen parallele Hauptoberflächen (18, 20) hat, wobei die gegenüberliegenden Oberflächen die oberste (18) bzw. unterste (20) sind;

b) Ablagern einer regelmäßigen Anordnung von Tropfen (24) in fester Form auf der oberen Oberfläche, wobei die Tropfen metallreiches leitfähiges Material enthalten;

c) Aufbringen einer Schicht aus Puffermaterial (70) auf die gesamte Fläche der unteren Oberfläche, wobei das Puffermaterial die Eigenschaft besitzt, in den Tropfen unlöslich zu sein, wobei die Schicht dadurch direkt in Kontakt mit der unteren Oberfläche und der Heizfläche tritt, wenn die untere Oberfläche in innigste Nachbarschaft zu der Heizfläche gebracht wird, wobei die Pufferschicht die Wanderung der Tropfen beendet, um eine Legierungsbildung der Tropfen mit der Heizfläche zu vermeiden;

d) Anordnen des Wafer-Körpers auf einer im allgemeinen ebenen Fläche der Heizvorrichtung (40), wobei die Gesamtfläche der Körperoberfläche in innigster Berührung mit der Heizfläche ist;

e) Erwärmen des Wafer-Körpers und der Tropfen auf eine ausreichende Temperatur, um gleichzeitig:

I) einen Temperaturgradienten durch den Wafer-Körper (14) zu errichten, worin die untere Oberfläche (20) auf einer höheren Temperatur ist als die obere Fläche (18), und

II) Schmelzen der Tropfen (24), um eine Wanderung der Tropfen durch den Wafer-Körper auf die erwärmte Fläche hin zu ermöglichen; und

f) Entfernen von Hitze von der oberen Oberfläche zur Vergrößerung der Errichtung des Temperaturgradienten; wodurch die Tropfen säulenartige Wege bilden, deren Leitfähigkeit der Leitfähigkeit des Wafer-Körpers entgegengesetzt ist.

2. Verfahren nach Anspruch 1, wobei der Wafer-Körper Silikon enthält.

3. Verfahren nach Anspruch 2, wobei der Wafer-Körper Silikon vom n-Typ und die Tropfen Aluminium enthalten.

4. Apparat zur Erzeugung eines Halbleiter-Wafers durch Temperaturgradienten-Zonenschmelzen, wobei der Wafer im allgemeinen parallele gegenüberliegende obere und untere Oberflächen besitzt, wobei der Apparat umfaßt:

a) eine Grundplatte (34);

b) eine auf der Grundplatte montierte drehbare Heizvorrichtung (40), wobei die Heizvorrichtung eine im allgemeinen ebene Heizfläche besitzt, die die gesamte Fläche der Grundfläche des Halbleiter-Wafers unterstützen kann;

c) eine Quelle für wärmeleitfähiges Gas;

d) eine Kühlkörpervorrichtung (46) in genügendem Abstand zur Heizvorrichtung (40), aber in enger Nachbarschaft hierzu, so daß beim Anbringen eines Halbleiter-Wafers auf der Heizvorrichtung ein Raum (48) zwischen der Heizvorrichtung und der Kühlkörpervorrichtung gebildet wird, der ein Gas mit hoher Wärmeleitfähigkeit aufnehmen kann, so daß die Kühlkörpervorrichtung und das Gas in Zusammenwirken die Hitze von dem Inneren des Wafer-Körpers durch die obere Oberfläche des Halbleiter-Wafers abführen, um die Errichtung eines thermalen Temperaturgradienten zu verstärken; und

e) eine Vorrichtung in Verbindung mit der Quelle für wärmeleitendes Gas zur Erzeugung eines Einlaßes (56) und Auslaßes (58) des wärmeleitfähigen Gases nach und von dem Raum (48).

5. Apparat nach Anspruch 4, enthaltend ferner eine obere Wand (32), die geeignet ist, entfernbar auf der Grundplatte (34) montiert zu werden, um dadurch eine geschlossene Kammer zu umgrenzen, die die Heizvorrichtung (49), die Kühlkörpervorrichtung (46) und den Gasraum (48) darin enthält.

6. Apparat nach Anspruch 4 oder 5, wobei die Kühlkörpervorrichtung (46) einen Tank zur Aufnahme von Kühlwasser enthält.

7. Apparat nach einem der Ansprüche 4 bis 6, wobei die drehbare Heizvorrichtung eine Graphitplattform enthält und Hochfrequenz-Spulen (44) sind benachbart zu der Graphitplattform angeordnet, um in ihnen wärmeerzeugende Ströme zu induzieren.

**Revendications**

1. Procédé pour fabriquer un dispositif semiconducteur par fusion à zone de gradient thermique comprenant les étapes qui consistent:

a) à choisir un corps de tranche (14) en matière semi-conductrice qui est d'un premier type de conductivité, ledit corps présentant deux surfaces principales opposées globalement parallèles (18, 20), lesdites surfaces opposées étant, respectivement, les surfaces supérieure (18) et inférieure (20);

b) à déposer un ensemble aligné de gouttelettes (24) sous forme solide sur ladite surface supérieure, lesdites gouttelettes comprenant une matière conductrice riche en métal;

c) à appliquer une couche d'une matière tampon (70) sur la totalité de l'étendue de ladite surface inférieure, ladite matière tampon ayant pour caractéristique d'être insoluble avec lesdites gouttelettes, ladite couche étant ainsi en contact direct avec ladite surface inférieure et ladite surface chauffante lorsque ladite surface inférieure est placée de façon à être intimement adjacent à ladite surface chauffante, de manière que ladite couche tampon arrête ladite migration desdites gouttelettes pour empêcher l'alliage desdites gouttelettes avec ladite surface chauffante;

d) à placer ledit corps de tranche sur une surface globalement plane de moyens chauffants (40) de façon que la totalité de l'étendue de ladite surface inférieure soit intimement adjacente à ladite surface chauffante;

e) à chauffer ledit corps de tranche et lesdites gouttelettes à une température suffisante pour, simultanément:

(i) établir un gradient thermique à travers ledit corps de tranche (14) tel que ladite surface inférieure (20) soit à une température plus élevée que ladite surface supérieure (18), et

(ii) faire fondre lesdites gouttelettes (24) pour permettre la migration desdites gouttelettes à travers ledit corps de tranche vers ladite surface chauffante; et

f) à enlever de la chaleur de ladite surface supérieure pour favoriser l'établissement dudit gradient thermique; de manière que lesdites gouttelettes forment des voies analogues à des colonnes dont la conductivité est opposée à la conductivité dudit corps de tranche.

2. Procédé selon la revendication 1, dans lequel ledit corps de tranche comprend du silicium.

3. Procédé selon la revendication 2, dans lequel ledit corps de tranche comprend du silicium de type *n* et lesdites gouttelettes comprennent de l'aluminium.

4. Appareil pour la fabrication d'une tranche de semi-conducteurs par fusion à zone de gradient thermique, ladite tranche présentant des surfaces opposées supérieure et inférieure globalement parallèles, ledit appareil comprenant:

a) une base (34);

b) des moyens chauffants rotatifs (40) montés sur ladite base, lesdits moyens chauffants présentant une surface chauffante globalement plane qui est capable de supporter toute l'étendue de la surface inférieure de la tranche semi-conductrice;

c) une source de gaz conducteur de la chaleur;

d) des moyens (46) de dissipation de la chaleur suffisamment espacés des moyens chauffants (40), mais tout en étant très rapprochés, pour que, lorsqu'une tranche semi-conductrice est placée sur lesdits moyens chauffants, un espace (48) entre lesdits moyens chauffants et lesdits moyens de dissipation de la chaleur soit formé et puisse recevoir un gaz hautement conducteur de la chaleur, de façon que lesdits moyens de dissipation de la chaleur et ledit gaz éliminent, en coopérant, de la chaleur de l'intérieur dudit corps de tranche à travers la surface supérieure de ladite tranche semi-conductrice pour favoriser l'établissement d'un gradient thermique de température; et

e) des moyens communiquant avec ladite source de gaz conducteur de la chaleur et formant une entrée (56) dudit gaz conducteur de la chaleur vers ledit espace (48) et une sortie (58) dudit gaz conducteur de la chaleur à partir dudit espace (48).

5. Appareil selon la revendication 4, comprenant en outre une paroi supérieure (32) conçue pour être montée de façon amovible sur ladite base (34) afin de définir une chambre fermée contenant lesdits moyens chauffants (40), lesdits moyens (46) de dissipation de chaleur et ledit espace (48) pour le gaz.

6. Appareil selon la revendication 4 ou 5, dans lequel lesdits moyens (46) de dissipation de la chaleur comprennent une cuve destinée à recevoir de l'eau de refroidissement.

7. Appareil selon l'une quelconque des revendications 4 à 6, dans lequel desdits moyens chauffants rotatifs comprennent un plateau en graphite et des bobines (44) à radiofréquence sont positionnées à proximité immédiate dudit plateau en graphite pour y induire des courants générateurs de chaleur.

Fig. 1.

Fig. 4.  Fig. 5.  Fig. 6.  Fig. 7.

Fig. 3.

Fig. 2.

# Fig. 8.